# EUROPEAN PATENT APPLICATION

(11) **EP 4 776 286 A1**
(43) Date of publication of application: **15.07.2026**
(21) Application number: 26150179.5
(22) Date of filing: 05.01.2026
(51) Int. Cl.: G11C 8/12, G11C 16/04, G11C 16/08

(54) **NONVOLATILE MEMORY DEVICE, OPERATION METHOD OF NONVOLATILE MEMORY DEVICE, AND STORAGE DEVICE INCLUDING NONVOLATILE MEMORY DEVICE**

(30) Priority: 13.01.2025 KR 20250005066; 26.11.2025 US 202519402896
(71) Applicant: Samsung Electronics Co., Ltd., Suwon-si, Gyeonggi-do 16677 (KR)
(72) Inventor: LEE, Hyunee, 16677 Suwon-si (KR); SONG, Seunghwan, 16677 Suwon-si (KR); KIM, Wandong, 16677 Suwon-si (KR); JEONG, Youngseok, 16677 Suwon-si (KR); SONG, Seongjin, 16677 Suwon-si (KR); CHOI, Youngha, 16677 Suwon-si (KR)
(74) Representative: Marks & Clerk LLP

(57) **Abstract**

A nonvolatile memory device which includes a memory cell array that includes a plurality of cell strings having a plurality of memory cells classified into pages, a row decoder that is connected to the memory cell array through string selection lines, ground selection lines, and word lines, and a page buffer that is connected to the memory cell array through bit lines. In response to that a read command for a first page is received from an external device, the row decoder applies first voltages to the word lines to correspond to first capacitances of memory cells of the first page. In response to that a read command for a first partial page of the first page is received from the external device, the row decoder applies second voltages to the word lines to correspond to second capacitances of memory cells of the first partial page.

## Description

### BACKGROUND

Embodiments of the present disclosure described herein relate to an electronic device, and more particularly, relate to a nonvolatile memory device reducing power consumption, an operation method of the nonvolatile memory device, and a storage device including the nonvolatile memory device.

Semiconductor memory devices may refer to memory devices which are implemented by using a semiconductor such as silicon (Si), germanium (Ge), gallium arsenide (GaAs), or indium phosphide (InP). The semiconductor memory devices may be mainly classified as a volatile memory or a nonvolatile memory.

The volatile memory device may refer to a memory device which loses data stored therein when a power is turned off. The volatile memory includes a static random access memory (SRAM), a dynamic RAM (DRAM), a synchronous DRAM, etc. The nonvolatile memory may refer to a memory device which retains data stored therein even when a power is turned off. The nonvolatile memory may include a read only memory (ROM), a programmable ROM (PROM), an electrically programmable ROM (EPROM), an electrically erasable and programmable ROM (EEPROM), a flash memory, a phase-change RAM (PRAM), a magnetic RAM (MRAM), a resistive RAM (RRAM), etc.

As semiconductor memory devices become increasingly highly integrated, various research efforts are underway to reduce power consumption. Therefore, in highly integrated memory devices, methods for reducing power consumption continue to be a topic of research and development.

### SUMMARY

Embodiments of the present disclosure provide a nonvolatile memory device reducing power consumption, an operation method of the nonvolatile memory device, and a storage device including the nonvolatile memory device.

According to an embodiment, a nonvolatile memory device includes a memory cell array that includes a plurality of cell strings having a plurality of memory cells classified into pages, a row decoder that is connected to the memory cell array through string selection lines, ground selection lines, and word lines and configured to apply voltages to the string selection lines and the ground selection lines, and a page buffer that is connected to the memory cell array through bit lines and configured to apply voltages to the bit lines. In response to that a read command for a first page is received from an external device, the row decoder is configured to apply first voltages to the word lines to correspond to first capacitances of memory cells of the first page. In response to that a read command for a first partial page of the first page is received from the external device, the row decoder is configured to apply second voltages to the word lines to correspond to second capacitances of memory cells of the first partial page. The nonvolatile memory device (100) is configured such that a channel of each cell string is formed having a channel voltage in response to the voltages being applied to the string selection lines, the ground selection lines, the word lines, and the bit lines. The nonvolatile memory device (100) is configured such that the first capacitances are formed between channels of strings connected to bit lines associated with the first page and the word lines being applied with the first voltages. The nonvolatile memory device (100) is configured such that the second capacitances are formed between channels of strings connected to bit lines associated with the first partial page and the word lines being applied with the second voltages. An amount of the second capacitances is less than an amount of the first capacitances.

According to an embodiment, an operation method of a nonvolatile memory device which includes a memory cell array including a plurality of cell strings having a plurality of memory cells classified into pages includes applying first voltages to word lines to correspond to first capacitances of memory cells of a first page in response to that a read command for the first page is received from an external device, applying second voltages to the word lines to correspond to second capacitances of memory cells of a first partial page of the first page in response to that a read command for the first partial page is received from the external device, and forming a channel of each cell string having a channel voltage by applying the voltages to the string selection lines, the ground selection lines, the word lines, and the bit lines. The first capacitances are formed between channels of strings connected to bit lines associated with the first page and the word lines being applied with the first voltages. The second capacitances different from the first capacitances are formed between channels of strings connected to bit lines associated with the first partial page and the word lines being applied with the second voltages.

According to an embodiment, a storage device includes a nonvolatile memory device, and a controller configured to access the nonvolatile memory device. The nonvolatile memory device includes a memory cell array including a plurality of cell strings having a plurality of memory cells classified into pages, a row decoder connected to the memory cell array through string selection lines, ground selection lines, and word lines and configured to apply voltages to the string selection lines and the ground selection lines, and a page buffer connected to the memory cell array through bit lines and configured to apply voltages to the bit lines. In response to that a read command for a first page is received from the controller, the row decoder is configured to apply first voltages to the word lines to correspond to first capacitances of memory cells of the first page. In response to that a read command for a first partial page of the first page is received from the controller, the row decoder is configured to apply second voltages to the word lines to correspond to second capacitances of memory cells of the first partial page. The nonvolatile memory device (100) is configured such that the first capacitances are formed between channels of strings connected to bit lines associated with the first page and the word lines being applied with the first voltages. The nonvolatile memory device (100) is configured such that the second capacitances different from the first capacitances are formed between channels of strings connected to bit lines associated with the first partial page and the word lines being applied with the second voltages.

At least some of the above and other features of the invention are set out in the claims.

### BRIEF DESCRIPTION OF THE FIGURES

The above and other objects and features of the present disclosure will become apparent by describing in detail embodiments thereof with reference to the accompanying drawings.
FIG. 1 is a block diagram illustrating a nonvolatile memory device according to an embodiment of the present disclosure.
FIG. 2 illustrates an example of a portion of one of memory blocks included in a first plane or a second plane.
FIG. 3 illustrates a first example of an operation method of a nonvolatile memory device.
FIG. 4 illustrates an example of a process of performing a partial access operation in a memory block of FIG. 2.
FIG. 5 illustrates an example of a method in which a nonvolatile memory device according to an embodiment of the present disclosure performs a partial access operation in a state where the nonvolatile memory device inhibits at least some of partial cell strings structurally associated with partial cell strings targeted for partial access from acting as the load of word lines.
FIG. 6 illustrates an example in which first to eighth special memory cells are programmed in a memory block of FIG. 2 according to example embodiments.
FIG. 7 illustrates an example in which a nonvolatile memory device suffers from only the load of a first partial cell string targeted for a partial access operation according to example embodiments.
FIG. 8 illustrates an example of groups of a plurality of bit lines according to example embodiments.
FIG. 9 illustrates another example of groups of a plurality of bit lines according to example embodiments.
FIG. 10 illustrates an example of a nonvolatile memory device according to an application example for performing a partial access operation in a state where at least some of partial cell strings do not act as the load of word lines, according to example embodiments.
FIG. 11 illustrates an example of an operation method of a nonvolatile memory device of FIG. 10 according to example embodiments.
FIG. 12 illustrates an example in which cell strings are floated by a nonvolatile memory device of FIG. 10 and an operation method of FIG. 11 according to example embodiments.
FIG. 13 illustrates an application example in which cell strings are floated by a nonvolatile memory device of FIG. 10 and an operation method of FIG. 11 according to example embodiments.
FIG. 14 illustrates an example of an operation method of a nonvolatile memory device of FIG. 1 or 10 according to example embodiments.
FIG. 15 illustrates an example in which an operation method of FIG. 14 is performed in cell strings of FIG. 2 according to example embodiments.
FIG. 16 is a diagram illustrating a storage device according to an embodiment of the present disclosure.
FIG. 17 is a diagram illustrating a system according to an embodiment of the present disclosure.

### DETAILED DESCRIPTION

Below, embodiments of the present disclosure will be described in detail and clearly to such an extent that a person of ordinary skill in the art may easily carry out the present disclosure.

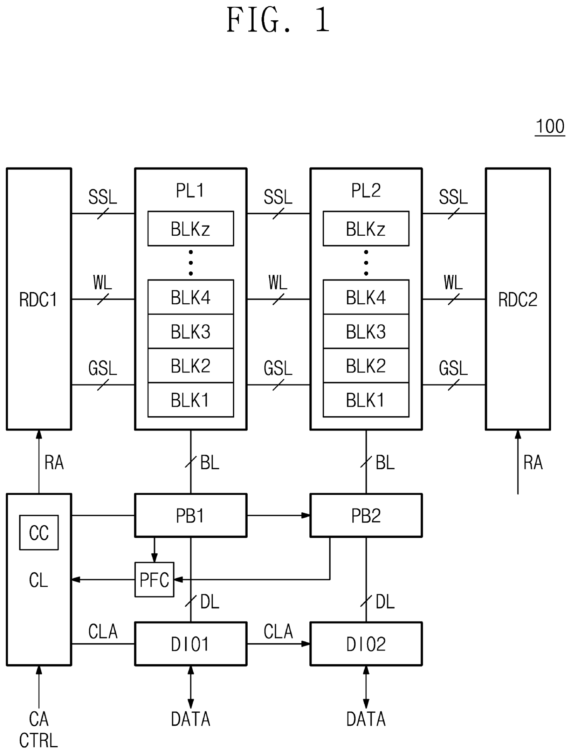

FIG. 1 is a block diagram illustrating a nonvolatile memory device 100 according to an embodiment of the present disclosure. Referring to FIG. 1, the nonvolatile memory device 100 includes a first plane PL1, a second plane PL2, a first row decoder RDC1, a second row decoder RDC2, a first page buffer PB1, a second page buffer PB2, a pass/fail check block (or pass/fail check circuit) PFC, a first data input and output circuit DIO1, a second data input and output circuit DIO2, and a control logic circuit CL.

Each of the first plane PL1 and the second plane PL2 includes a plurality of memory blocks BLK1 to BLKz. Each of the memory blocks BLK1 to BLKz includes a plurality of memory cells. Each of the memory blocks BLK1 to BLKz may be connected to the first row decoder RDC1 and the second row decoder RDC2 through at least one ground selection line GSL, word lines WL, and at least one string selection line SSL. Some of the word lines WL may be used as dummy word lines. Each of the memory blocks BLK1 to BLKz may be connected to the first page buffer PB1 or the second page buffer PB2 through a plurality of bit lines BL. For example, the memory blocks BLK1 to BLKz of the first plane PL1 may be connected to the first page buffer PB1 through the plurality of bit lines BL, and the memory blocks BLK1 to BLKz of the second plane PL2 may be connected to the second page buffer PB2 through the plurality of bit lines BL. The memory blocks BLK1 to BLKz of the first plane PL1 and the memory blocks BLK1 to BLKz of the second plane PL2 may be connected in common to the plurality of bit lines BL.

In an embodiment, each of the plurality of memory blocks BLK1 to BLKz may correspond to a unit of the erase operation. Memory cells belonging to each memory block may be erased at the same time. As another example, each memory block may be divided into a plurality of sub-blocks. Each of the plurality of sub-blocks may correspond to a unit of the erase operation.

The first row decoder RDC1 and the second row decoder RDC2 are connected to the first plane PL1 and the second plane PL2 through the ground selection lines GSL, the word lines WL, and the string selection lines SSL. The first row decoder RDC1 and the second row decoder RDC2 operate under control of the control logic circuit CL.

The first row decoder RDC1 and the second row decoder RDC2 may decode a row address RA received from the control logic circuit CL and may control voltages to be applied to the string selection lines SSL, the word lines WL, and the ground selection lines GSL depending on the decoded row address.

The first page buffer PB1 and the second page buffer PB2 are respectively connected to the first plane PL1 and the second plane PL2 through the plurality of bit lines BL. The first page buffer PB1 and the second page buffer PB2 are respectively connected to the first data input and output circuit DIO1 and the second data input and output circuit DIO2 through a plurality of data lines DL. The first page buffer PB1 and the second page buffer PB2 operate under control of the control logic circuit CL.

In the program operation, the first page buffer PB1 or the second page buffer PB2 may store data to be written in memory cells. Based on the stored data, the first page buffer PB1 or the second page buffer PB2 may apply the voltages to the plurality of bit lines BL. In the read operation or in the verify read operation which performed in the program operation or the erase operation, the first page buffer PB1 or the second page buffer PB2 may sense voltages of the bit lines BL and may store a result of the sensing.

In the verify read operation associated with the program operation or the erase operation, the pass/fail check block PFC may verify the sensing result of the first page buffer PB1 or the second page buffer PB2. For example, in the verify read operation which is performed in the program operation, the pass/fail check block PFC may count the number of values (e.g., the number of 0s) corresponding to on-cells which are not programmed to a target threshold voltage or higher.

In the verify read operation which is performed in the erase operation, the pass/fail check block PFC may count the number of values (e.g., the number of 1s) corresponding to off-cells which are not erased to a target threshold voltage or lower. When the counting result is greater than or equal to a threshold value, the pass/fail check block PFC may output a fail signal to the control logic circuit CL. When the counting result is smaller than the threshold value, the pass/fail check block PFC may output a pass signal to the control logic circuit CL. Depending on a result of the verification of the pass/fail check block PFC, a program loop of the program operation may be further performed, or an erase loop of the erase operation may be further performed.

The first data input and output circuit DIO1 and the second data input and output circuit DIO2 are respectively connected to the first page buffer PB1 and the second page buffer PB2 through the plurality of data lines DL. The first data input and output circuit DIO1 and the second data input and output circuit DIO2 may receive a column address (or a decoded column address) CLA from the control logic circuit CL. The first data input and output circuit DIO1 and the second data input and output circuit DIO2 may respectively output data "DATA" read from the first page buffer PB1 and the second page buffer PB2 to an external device depending on the column address CLA. The first data input and output circuit DIO1 and the second data input and output circuit DIO2 may respectively transfer the data "DATA" received from the external device to the first page buffer PB1 and the second page buffer PB2, depending on the column address CLA.

The control logic circuit CL may receive a command and address CA from the external device. The control logic CL circuit may decode the command and address CA received from the external device and may control the nonvolatile memory device 100 depending on the decoded command and address CA. For example, the control logic circuit CL may provide the row address RA to the first row decoder RDC1 and the second row decoder RDC2. The control logic circuit CL may provide the column address CLA to the first data input and output circuit DIO1 and the second data input and output circuit DIO2.

The control logic circuit CL may include a capacitance control circuit CC. The capacitance control circuit CC may prevent the increase in a power, which is used to bias (or apply) voltages of the word lines WL, due to an unintended capacitance when the nonvolatile memory device 100 accesses (e.g., performs the write or read operation on) memory cells of the first plane PL1 or the second plane PL2.

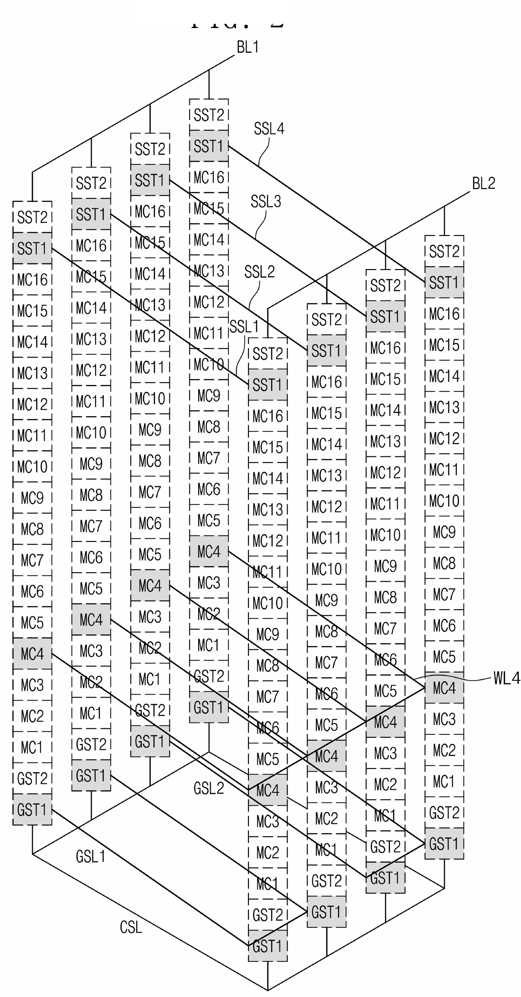

FIG. 2 illustrates an example of a portion of one of the memory blocks BLK1 to BLKz included in the first plane PL1 or the second plane PL2. Referring to FIGS. 1 and 2, one of the memory blocks BLK1 to BLKz may include a plurality of cell strings. Each cell string may be a stack of cell transistors which are connected to one of first and second bit lines BL1 and BL2 and are connected to one of first to fourth string selection lines SSL1 to SSL4.

Each of the plurality of cell strings may include a first ground selection transistor GST1 and a second ground selection transistor GST2 sequentially stacked, first to sixteenth memory cells MC1 to MC16 sequentially stacked on the second ground selection transistor GST2, and a first string selection transistor SST1 and a second string selection transistor SST2 sequentially stacked on the sixteenth memory cell MC16.

In FIG. 2, directions in which the first string selection line SSL1, the second string selection line SSL2, the third string selection line SSL3, and the fourth string selection line SSL4 extend may be referred to as "row directions". The first string selection line SSL1 is referred to as "corresponding to a first row of cell strings", the second string selection line SSL2 is referred to as "corresponding to a second row of cell strings", the third string selection line SSL3 is referred to as "corresponding to a third row of cell strings", and the fourth string selection line SSL4 is referred to as "corresponding to a fourth row of cell strings".

Directions in which the first bit line BL1 and the second bit line BL2 extend may be referred to as "column directions". The first bit line BL1 is referred to as "corresponding to a first column of cell string", and the second bit line BL2 is referred to as "corresponding to a second column of cell strings".

The first ground selection transistors GST1 of the plurality of cell strings may be connected in common to a common source line CSL.

As shaded in FIG. 2, the first ground selection transistors GST1 of the cell strings in the first row and the first ground selection transistors GST1 of the cell strings in the second row may be connected in common to a first ground selection line GSL1. The first ground selection transistors GST1 of the cell strings in the third row and the first ground selection transistors GST1 of the cell strings in the fourth row may be connected in common to a second ground selection line GSL2.

As described with reference to the first ground selection transistors GST1, the second ground selection transistors GST2 of the cell strings in the first row and the second ground selection transistors GST2 of the cell strings in the second row may be connected in common to a third ground selection line (e.g., GSL3). The second ground selection transistors GST2 of the cell strings in the third row and the second ground selection transistors GST2 of the cell strings in the fourth row may be connected in common to a fourth ground selection line (e.g., GSL4).

As shaded in FIG. 2, the fourth memory cells MC4 of the cell strings in the first row, the fourth memory cells MC4 of the cell strings in the second row, the fourth memory cells MC4 of the cell strings in the third row, and the fourth memory cells MC4 of the cell strings in the fourth row may be connected in common to a fourth word line WL4.

As described with reference to the fourth memory cells MC4, the first memory cells MC1, the second memory cells MC2, and the third memory cells MC3 of the cell strings in the first row, the first memory cells MC1, the second memory cells MC2, and the third memory cells MC3 of the cell strings in the second row, the first memory cells MC1, the second memory cells MC2, and the third memory cells MC3 of the cell strings in the third row, and the first memory cells MC1, the second memory cells MC2, and the third memory cells MC3 of the cell strings in the fourth row may be connected in common to a first word line (e.g., WL1), a second word line (e.g., WL2), and a third word line (e.g., WL3), respectively.

As described with reference to the fourth memory cells MC4, the fifth memory cells MC5, the sixth memory cells MC6, the seventh memory cells MC7, the eighth memory cells MC8, the ninth memory cells MC9, the tenth memory cells MC10, the eleventh memory cells MC11, the twelfth memory cells MC12, the thirteenth memory cells MC13, the fourteenth memory cells MC14, the fifteenth memory cells MC15, and the sixteenth memory cells MC16 of the cell strings of the first row, the fifth memory cells MC5, the sixth memory cells MC6, the seventh memory cells MC7, the eighth memory cells MC8, the ninth memory cells MC9, the tenth memory cells MC10, the eleventh memory cells MC11, the twelfth memory cells MC12, the thirteenth memory cells MC13, the fourteenth memory cells MC14, the fifteenth memory cells MC15, and the sixteenth memory cells MC16 of the cell strings of the second row, the fifth memory cells MC5, the sixth memory cells MC6, the seventh memory cells MC7, the eighth memory cells MC8, the ninth memory cells MC9, the tenth memory cells MC10, the eleventh memory cells MC11, the twelfth memory cells MC12, the thirteenth memory cells MC13, the fourteenth memory cells MC14, the fifteenth memory cells MC15, and the sixteenth memory cells MC16 of the cell strings of the third row, and the fifth memory cells MC5, the sixth memory cells MC6, the seventh memory cells MC7, the eighth memory cells MC8, the ninth memory cells MC9, the tenth memory cells MC10, the eleventh memory cells MC11, the twelfth memory cells MC12, the thirteenth memory cells MC13, the fourteenth memory cells MC14, the fifteenth memory cells MC15, and the sixteenth memory cells MC16 of the cell strings of the fourth row may be connected in common to a fifth word line (e.g., WL5), a sixth word line (e.g., WL6), a seventh word line (e.g., WL7), an eighth word line (e.g., WL8), a ninth word line (e.g., WL9), a tenth word line (e.g., WL10), an eleventh word line (e.g., WL11), a twelfth word line (e.g., WL12), a thirteenth word line (e.g., WL13), a fourteenth word line (e.g., WL14), a fifteenth word line (e.g., WL15), and a sixteenth word line (e.g., WL16), respectively.

In an embodiment, in cell strings belonging to one row, memory cells placed at the same height may form one page. In an embodiment, a page connected to one word line (e.g., the fourteenth word line WL14) from among pages of one memory block (e.g., BLK1) among the first to z-th memory blocks BLK1 to BLKz of the first plane PL1 may be used as a super page together with a page connected to one word line (e.g., the fourteenth word line WL14) from among pages of one memory block (e.g., BLK1) among the first to z-th memory blocks BLK1 to BLKz of the second plane PL2.

As shaded in FIG. 2, the first string selection transistors SST1 of the cell strings in the first row may be connected to the first string selection line SSL1, the first string selection transistors SST1 of the cell strings in the second row may be connected to the second string selection line SSL2, the first string selection transistors SST1 of the cell strings in the third row may be connected to the third string selection line SSL3, and the first string selection transistors SST1 of the cell strings in the fourth row may be connected to the fourth string selection line SSL4.

The second string selection transistor SST2 of the first row, the second string selection transistor SST2 of the second row, the second string selection transistor SST2 of the third row, and the second string selection transistor SST2 of the fourth row may be respectively connected to a fifth string selection line (e.g., SSL5), a sixth string selection line (e.g., SSL6), a seventh string selection line (e.g., SSL7), and an eighth string selection line (e.g., SSL8).

To prevent a drawing from being unnecessarily complicated, some lines and reference signs of some lines are omitted in FIG. 2.

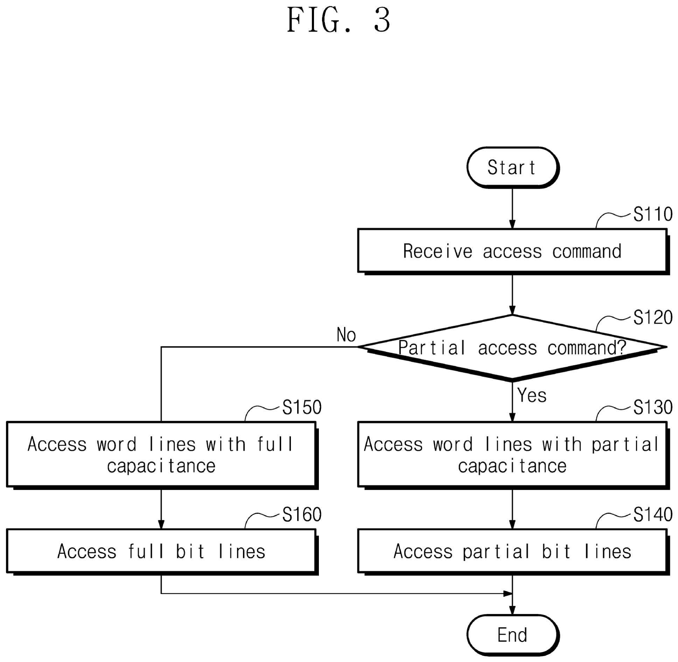

FIG. 3 illustrates a first example of an operation method of the nonvolatile memory device 100. Referring to FIGS. 1 and 3, in operation S110, the nonvolatile memory device 100 may receive an access command. For example, the nonvolatile memory device 100 may receive the access command from an external storage controller or a memory controller. The access command may include a write command, a read command, or an erase command.

In operation S120, the nonvolatile memory device 100 may determine whether the received access command is a partial access command. For example, when the access command requests an access of one super page of the first plane PL1 and the second plane PL2 of the nonvolatile memory device 100, that is, when the access command is received together with an address (e.g., a physical address) indicating the whole of one super page, the access command may be identified as a full access command. When the access command requests an access to a portion of one super page the first plane PL1 and the second plane PL2 of the nonvolatile memory device 100, that is, when the access command is received together with an address (e.g., a physical address) indicating a portion of one super page, the access command may be identified as a partial access command.

When the received access command is the partial access command, in operation S130, the nonvolatile memory device 100 may access word lines with partial capacitances. In operation S140, the nonvolatile memory device 100 may access partial bit lines to continue a partial access operation.

For example, in the partial access operation, cell strings may include first partial cell strings including cell strings targeted for access and second partial cell strings not including the cell strings targeted for access. The first partial cell strings may include third partial cell strings including the cell strings targeted for access (or being the cell strings targeted for access) and fourth partial cell strings operating in association with the third partial cell strings due to a structural characteristic of the first plane PL1 and the second plane PL2.

The first row decoder RDC1 and the second row decoder RDC2 may experience the load of the capacitance of the third partial cell strings and the fourth partial cell strings of the cell strings connected to the first to sixteenth word lines WL1 to WL16 of the first plane PL1 and the second plane PL2 when biasing both the third partial cell strings and the fourth partial cell strings; in contrast, the first row decoder RDC1 and the second row decoder RDC2 may only experience the load of the capacitance of the third partial cell strings when biasing only the third partial cell strings.

In an embodiment, the biasing of the cell string may include forming a channel of the cell string having a channel voltage by applying a specific voltage through the first bit line BL1, the second bit line BL2, or the common source line CSL and applying a bias voltage to the cell string through the first to sixteenth word lines WL1 to WL16. For example, the biasing of the cell string may further include applying a specific voltage through the first and second string selection transistors SST1 and SST2, and the first and second ground selection transistors GST1 and GST2. Based on the coupling effect, the channel voltage of the cell string may act as the load of the first to sixteenth word lines WL1 to WL16. That is, the biasing of the cell string may include applying voltages to the first to sixteenth word lines WL1 to WL16 where the cell string acts as the load.

When the received access command is not the partial access command but the full access command, in operation S150, the nonvolatile memory device 100 may access word lines with full capacitances. For example, the nonvolatile memory device 100 may experience the load of the capacitance of both the third partial cell strings and the fourth partial cell strings by biasing both the third partial cell strings and the fourth partial cell strings. In operation S160, the nonvolatile memory device 100 may access full bit lines to continue a full access operation.

The number of bit lines accessed by the partial access operation is less than the number of bit lines accessed by the full access operation. In general, in the partial access operation and the full access operation, there may be performed an operation of biasing the cell strings without a capacitance load difference. In contrast, a nonvolatile memory device according to an embodiment of the present disclosure may apply different capacitances to the partial access operation from the full access operation, and thus, the amount of power necessary to bias word lines in the partial access operation may be reduced. For example, an amount of capacitances of cell strings by the partial access operation may be less than an amount of capacitances of cell strings by the full access operation.

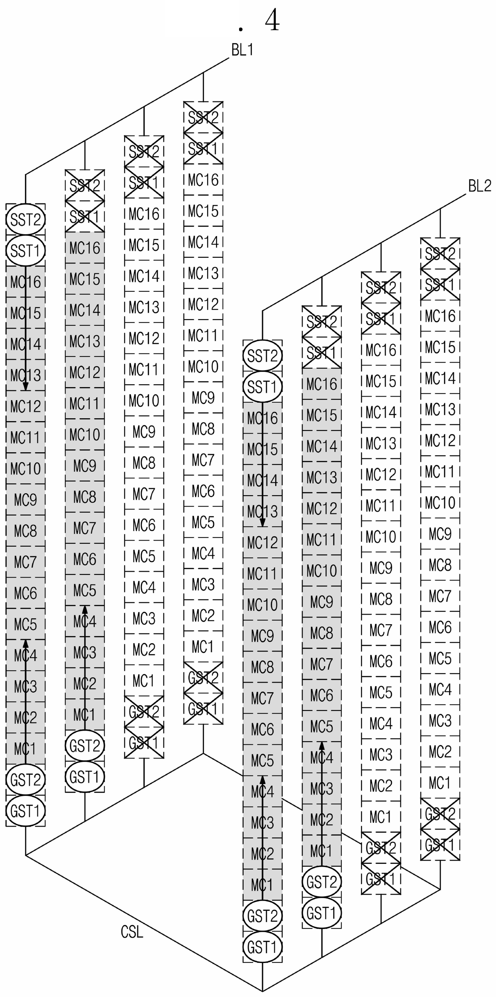

FIG. 4 illustrates an example of a process of performing a partial access operation in a memory block of FIG. 2. Referring to FIGS. 1, 2, and 4, in an embodiment, a target of the partial access operation may be a cell string connected to the first bit line BL1 (e.g., a selected bit line) and the first string selection line SSL1, and a cell string connected to the second bit line BL2 (e.g., a non-selected bit line) and the first string selection line SSL1 may not be a target for the partial access operation.

To bias the cell string targeted for the partial access operation, the first string selection transistors SST1 of the cell strings in the first row may be turned on by the first string selection line SSL1, and the second string selection transistors SST2 of the cell strings in the first row may be turned on by the corresponding string selection line (e.g., the fifth string selection line SSL5).

The first ground selection transistors GST1 of the cell strings in the first row may be turned on by the first ground selection line GSL1, and the second ground selection transistors GST2 of the cell strings in the first row may be turned on by the corresponding ground selection line (e.g., the third ground selection line GSL3).

The first to sixteenth memory cells MC1 to MC16 connected to the first string selection line SSL1 may have channels each having a channel voltage by a voltage supplied from the first bit line BL1 to the channels through the first string selection transistor SST1 and the second string selection transistor SST2 or a voltage supplied from the common source line CSL through the first ground selection transistor GST1 and the second ground selection transistor GST2.

In the configuration described with reference to FIG. 2, a cell string (e.g., the third partial cell string) connected to the first bit line BL1 and the first string selection line SSL1 as a partial access target as well as a cell string (e.g., the fourth partial cell string) connected to the second bit line BL2 and the first string selection line SSL1 may act as the load of the first to sixteenth word lines WL1 to WL16, and thus, power consumption may increase when word lines are driven.

The first string selection transistors SST1 of the cell strings in the second row may be turned off by the second string selection line SSL2, and the second string selection transistors SST2 of the cell strings in the second row may be turned off by the corresponding string selection line (e.g., the sixth string selection line SSL6).

The first ground selection transistors GST1 of the cell strings in the second row may be turned on by the first ground selection line GSL1, and the second ground selection transistors GST2 of the cell strings in the second row may be turned on by the corresponding ground selection line (e.g., the third ground selection line GSL3).

The first to sixteenth memory cells MC1 to MC16 connected to the second string selection line SSL2 may have channels each having a channel voltage by a voltage supplied from the common source line CSL through the first ground selection transistor GST1 and the second ground selection transistor GST2.

In the configuration described with reference to FIG. 2, a cell string (e.g., the third partial cell string) connected to the first bit line BL1 and the first string selection line SSL1 as a partial access target as well as a cell string (e.g., the fourth partial cell string) connected to the second bit line BL2 and the first string selection line SSL1 and cell strings (e.g., the fourth partial cell string) connected to the second string selection line SSL2 may act as the load of the first to sixteenth word lines WL1 to WL16, and thus, power consumption may increase when word lines are driven.

Because cell strings connected to the third string selection line SSL3, the fourth string selection line SSL4, and the second ground selection line GSL2 do not include a third partial cell string, the cell strings may be included in the second partial cell strings not including the cell strings targeted for access. Because all of the first string selection transistors SST1, the second string selection transistors SST2, the first ground selection transistors GST1, and the second ground selection transistors GST2 of the second partial cell string are turned off, the second partial cell strings may not act as the load of the first to sixteenth word lines WL1 to WL16.

As shaded in FIG. 4, in the structure described with reference to FIG. 2, both the third partial cell strings and the fourth partial cell strings may act as the load of the first to sixteenth word lines WL1 to WL16. To prevent the above described issue, the present disclosure is directed to provide embodiments in which at least some of the third partial cell strings and the fourth partial cell strings do not act as the load of word lines.

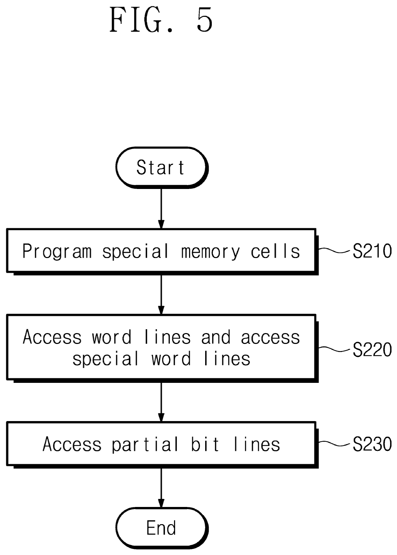

FIG. 5 illustrates an example of a method in which the nonvolatile memory device 100 according to an embodiment of the present disclosure performs the partial access operation in a state where the nonvolatile memory device 100 inhibits at least some of partial cell strings structurally associated with partial cell strings targeted for partial access from acting as the load of word lines.

Referring to FIGS. 1, 2, and 5, the nonvolatile memory device 100 may program special memory cells. The special memory cells may include some memory cells of the first to sixteenth memory cells MC1 to MC16 described with reference to FIG. 2. The special memory cells may not be used to store data (e.g., user data) and may be used to control channels of the remaining memory cells (i.e., memory cells used to store user data). A pattern of special data programmed in the special memory cells may be determined by a structure or operation characteristic of the nonvolatile memory device 100.

The special memory cells may support that the nonvolatile memory device 100 performs the partial access operation in a state where the nonvolatile memory device 100 inhibits at least some of partial cell strings (e.g., the fourth partial cell strings) structurally associated with cell strings (e.g., the third partial cell strings) targeted for partial access from acting as the load of word lines.

In operation S220, the nonvolatile memory device 100 may access word lines and may access special word lines. For example, the nonvolatile memory device 100 may apply voltages to the special word lines to bias or float channels of the third partial cell strings targeted for the partial access operation. The nonvolatile memory device 100 may apply voltage to word lines to perform the partial access operation.

In operation S230, the nonvolatile memory device 100 may access partial bit lines. For example, the nonvolatile memory device 100 may continue the partial access operation by accessing partial bit lines corresponding to the third partial cell strings targeted for the partial access operation.

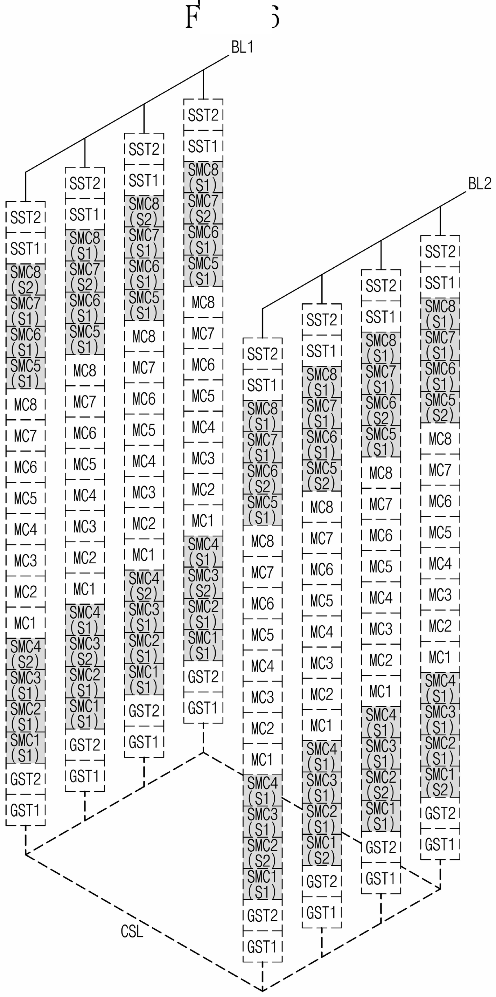

FIG. 6 illustrates an example in which first to eighth special memory cells SMC1 to SMC8 are programmed in a memory block of FIG. 2. Referring to FIGS. 2 and 6, in each cell string, four memory cells (e.g., the first to fourth memory cells MC1 to MC4 of FIG. 2) adjacent to the first ground selection transistor GST1 and the second ground selection transistor GST2 may be programmed as the first to fourth special memory cells SMC1 to SMC4.

In each cell string, four memory cells (e.g., the thirteenth to sixteenth memory cells MC13 to MC16 of FIG. 2) adjacent to the first string selection transistor SST1 and the second string selection transistor SST2 may be programmed as the fifth to eighth special memory cells SMC5 to SMC8.

In an embodiment, the first to fourth special memory cells SMC1 to SMC4 and the fifth to eighth special memory cells SMC5 to SMC8 may be programmed to have a predetermined state that is not user data. Herein, the user data may refer to information collected from users through various touchpoints, such as websites, applications, and interactions, to understand user behavior, preferences, and demographics for strategic decision-making and personalized user experiences.

In each cell string, memory cells (e.g., the fifth to twelfth memory cells MC5 to MC12 of FIG. 2) between the first to fourth special memory cells SMC1 to SMC4 and the fifth to eighth special memory cells SMC5 to SMC8 may be used as first to eighth memory cells MC1 to MC8 (e.g., normal memory cells configured to store user data).

Each special memory cell may be programmed to have one of a plurality of different states. The different states may correspond to different threshold voltage ranges. For example, each special memory cell may be programmed to belong to a threshold voltage range corresponding to one of a first state S1 and a second state S2. In an embodiment, it is assumed that each voltage within the threshold voltage range of the second state S2 is higher than each voltage within the threshold voltage range of the first state S1.

In each cell string, a pattern of states programmed in the first to fourth special memory cells SMC1 to SMC4 may be identical to a pattern of states programmed in the fifth to eighth special memory cells SMC5 to SMC8.

In an embodiment, the plurality of bit lines BL including the first bit line BL1 and the second bit line BL2 may be classified into a plurality of groups. The plurality of groups may correspond to the unit of the partial access operation. For example, when the nonvolatile memory device 100 supports the partial access operation of the 8-bit unit, the plurality of bit lines BL may be classified into a plurality of groups each including eight bit lines. When the nonvolatile memory device 100 supports the partial access operation of the 8KB unit, the plurality of bit lines BL may be classified into a plurality of groups each including 8KB bit lines.

In each of the plurality of groups, the first to fourth special memory cells SMC1 to SMC4 or the fifth to eighth special memory cells SMC5 to SMC8 sharing one ground selection line GSL1 or GSL2 may have different state patterns from each other. Based on different patterns, the first to fourth special memory cells SMC1 to SMC4 and the fifth to eighth special memory cells SMC5 to SMC8 may make it possible to apply only the channel load of the partial cell string targeted for the partial access operation to be applied to the first to eighth word lines WL1 to WL8 connected to the first to eighth memory cells MC1 to MC8.

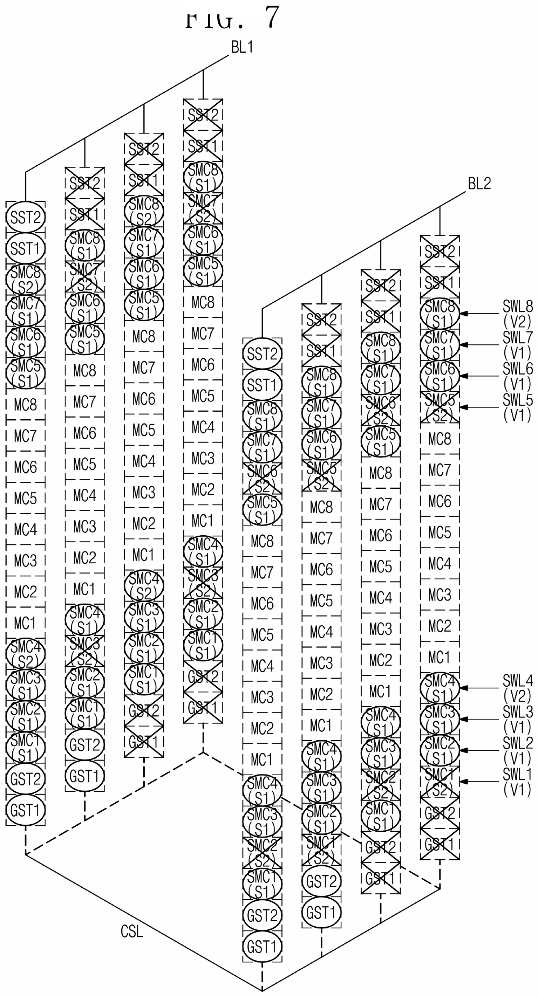

FIG. 7 illustrates an example in which the nonvolatile memory device 100 suffers from only the load of a third partial cell string targeted for a partial access operation. Referring to FIGS. 1 and 7, the nonvolatile memory device 100 may apply one of a first voltage V1 and a second voltage V2 to each of first to eighth special word lines SWL1 to SWL8 connected to the first to eighth special memory cells SMC1 to SMC8.

The first voltage V1 may have a voltage level between the threshold voltage range of the first state S1 and the threshold voltage range of the second state S2. That is, the first voltage V1 may turn on the special memory cell of the first state S1 and may turn off the special memory cell of the second state S2.

The second voltage V2 may have a voltage level higher than the threshold voltage range of the second state S2. That is, the second voltage V2 may turn on the special memory cell of the first state S1 and may turn on the special memory cell of the second state S2.

When the first voltage V1, the first voltage V1, the first voltage V1, and the second voltage V2 are respectively applied to first to fourth special word lines SWL1 to SWL4, the first to fourth special memory cells SMC1 to SMC4 of the third partial cell string at the first row and first column, which are connected to the first bit line BL1 and the first string selection line SSL1, may be turned on.

When the first voltage V1, the first voltage V1, the first voltage V1, and the second voltage V2 are respectively applied to fifth to eighth special word lines SWL5 to SWL8, the fifth to eighth special memory cells SMC5 to SMC8 of the third partial cell string at the first row and first column, which are connected to the first bit line BL1 and the first string selection line SSL1, may be turned on.

Because the first and second ground selection transistors GST1 and GST2 and the first and second string selection transistors SST1 and SST2 of the third partial cell string at the first row and first column are also turned on, the third partial cell string targeted for the partial access operation may act as the load of the first to eighth word lines WL1 to WL8.

When the first voltage V1, the first voltage V1, the first voltage V1, and the second voltage V2 are respectively applied to the first to fourth special word lines SWL1 to SWL4, the first, second, and fourth special memory cells SMC1, SMC2, and SMC4 of the fourth partial cell string at the second row and first column, which are connected to the first bit line BL1 and the second string selection line SSL2, may be turned on, and the third special memory cell SMC3 thereof may be turned off.

When the first voltage V1, the first voltage V1, the first voltage V1, and the second voltage V2 are respectively applied to the fifth to eighth special word lines SWL5 to SWL8, the fifth, sixth, and eighth special memory cells SMC5, SMC6, and SMC8 of the fourth partial cell string at the second row and first column, which are connected to the first bit line BL1 and the second string selection line SSL2, may be turned on, and the seventh special memory cell SMC7 thereof may be turned off.

The fourth partial cell string at the second row and first column may be disconnected from the common source line CSL by the turned-off third special memory cell SMC3 and may be disconnected from the first bit line BL1 by the turned-off first and second string selection transistors SST1 and SST2 and the turned-off seventh special memory cell SMC7. Accordingly, the fourth partial cell string at the second row and first column may be in a floating state and may not act as the load of the first to eighth word lines WL1 to WL8.

When the first voltage V1, the first voltage V1, the first voltage V1, and the second voltage V2 are respectively applied to the first to fourth special word lines SWL1 to SWL4, the first, third, and fourth special memory cells SMC1, SMC3, and SMC4 of the fourth partial cell string at the first row and second column, which are connected to the second bit line BL2 and the first string selection line SSL1, may be turned on, and the second special memory cell SMC2 thereof may be turned off.

When the first voltage V1, the first voltage V1, the first voltage V1, and the second voltage V2 are respectively applied to the fifth to eighth special word lines SWL5 to SWL8, the fifth, seventh, and eighth special memory cells SMC5, SMC7, and SMC8 of the fourth partial cell string at the first row and second column, which are connected to the second bit line BL2 and the first string selection line SSL1, may be turned on, and the sixth special memory cell SMC6 thereof may be turned off.

The fourth partial cell string at the first row and second column may be disconnected from the common source line CSL by the turned-off second special memory cell SMC2 and may be disconnected from the second bit line BL2 by the turned-off sixth special memory cell SMC6. Accordingly, the fourth partial cell string at the first row and second column may be in a floating state and may not act as the load of the first to eighth word lines WL1 to WL8.

As described with reference to FIG. 7, the nonvolatile memory device 100 according to an embodiment of the present disclosure may reduce the load to be applied to word lines in the partial access operation by using some of memory cells as special memory cells. Accordingly, the amount of power necessary to drive word lines may decrease.

In an embodiment, in the full access operation, the nonvolatile memory device 100 according to an embodiment of the present disclosure may apply the second voltage V2 to all the first to eighth special word lines SWL1 to SWL8. Because the first to eighth special memory cells SMC1 to SMC8 of the cell strings are turned on, the cell strings may be accessed by controlling the first and second ground selection transistors GST1 and GST2 and the first and second string selection transistors SST1 and SST2.

As another example, in the full access operation, the nonvolatile memory device 100 according to an embodiment of the present disclosure may use the patterns of the states of the first to eighth special memory cells SMC1 to SMC8 by applying the first voltage V1 and the second voltage V2 to the first to eighth special word lines SWL1 to SWL8.

For example, in FIG. 7, when the second voltage V2 is applied to the second and sixth special word lines SWL2 and SWL6, the second and sixth special memory cells SMC2 and SMC6 of the cell string of the first row may be turned on. That is, the cell strings of the first row may be selected for the full access operation. Accordingly, the load of the cell strings to be applied to the first to eighth word lines WL1 to WL8 in the full access operation may be reduced. Likewise, as the nonvolatile memory device 100 applies the first voltage V1 and the second voltage V2 to the first to eighth special word lines SWL1 to SWL8, the nonvolatile memory device 100 may select the cell strings of the second row for the full access operation and may inhibit the load of the cell strings of the first row from being applied to the first to eighth word lines WL1 to WL8.

In an embodiment, the number of special memory cells used in one cell string is not limited. Also, the number of states capable of being programmed in each special memory cell is not limited.

In an embodiment, operations of programming the first to eighth special memory cells SMC1 to SMC8 and appropriately applying the first voltage V1 and the second voltage V2 for the partial access operation to the first to eighth special word lines SWL1 to SWL8 may be controlled by the capacitance control circuit CC.

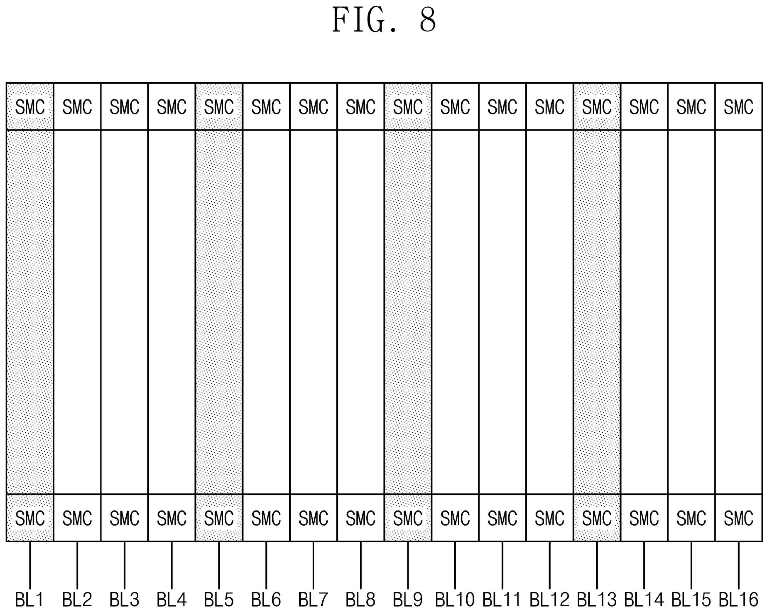

FIG. 8 illustrates an example of groups of the plurality of bit lines BL. Referring to FIG. 8, cell strings connected to the first to sixteenth bit lines BL1 to BL16 are illustrated. The special memory cells SMC may be provided at opposite ends of each cell string.

In an embodiment, each of the plurality of groups may include four bit lines, and thus, the nonvolatile memory device 100 may support the partial access operation corresponding to the 4-bit unit or a multiple of the 4-bit unit.

In an embodiment, a group of bit lines may be implemented depending on an input and output structure of the nonvolatile memory device 100. For example, the input and output structure of the nonvolatile memory device 100 may be based on a finger structure. In the input and output structure of the finger structure, the nonvolatile memory device 100 may select bit lines (e.g., BL1, BL5, BL9, and BL13) not adjacent thereto as a target of the input and output with an external device (e.g., a memory controller or a storage controller). Accordingly, the nonvolatile memory device 100 may select the bit lines BL1, BL5, BL9, and BL13 not adjacent thereto as one group.

Like the example illustrated in FIG. 8, groups including bit lines not adjacent thereto, for example, a group including the bit lines BL2, BL6, BL10, and BL14, a group including the bit lines BL3, BL7, BL11, and BL15, and a group including the bit lines BL4, BL8, BL12, and BL16 may be selected.

The number of bit lines included in each of the groups of a plurality of bit lines is not limited. The number of bit lines included in each group may vary depending on a structure characteristic or a required specification of the nonvolatile memory device 100.

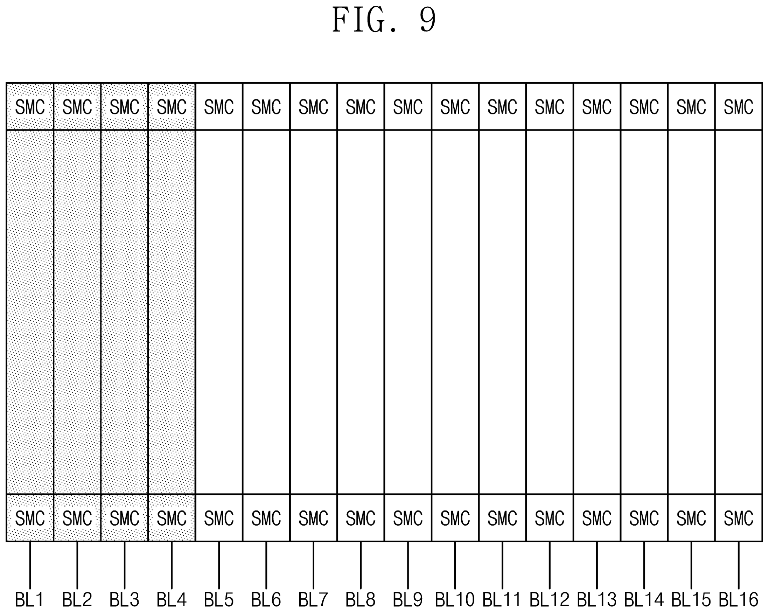

FIG. 9 illustrates another example of groups of the plurality of bit lines BL. Referring to FIG. 9, cell strings connected to the first to sixteenth bit lines BL1 to BL16 are illustrated. The special memory cells SMC may be provided at opposite ends of each cell string.

In an embodiment, each of the plurality of groups may include four bit lines, and thus, the nonvolatile memory device 100 may support the partial access operation corresponding to the 4-bit unit or a multiple of the 4-bit unit.

In an embodiment, a group of bit lines may be implemented depending on an input and output structure of the nonvolatile memory device 100. For example, the input and output structure of the nonvolatile memory device 100 may be based on a chunk structure. In the input and output structure of the chunk structure, the nonvolatile memory device 100 may select adjacent bit lines (e.g., BL1, BL2, BL3, and BL4) as a target of the input and output with an external device (e.g., a memory controller or a storage controller). Accordingly, the nonvolatile memory device 100 may select adjacent bit lines (e.g., BL1, BL2, BL3, and BL4) as one group.

Like the example illustrated in FIG. 9, groups including bit lines adjacent thereto, for example, a group including the bit lines BL5, BL6, BL7, and BL8, a group including the bit lines BL9, BL10, BL11, and BL12, and a group including the bit lines BL13, BL14, BL15, and BL16 may be selected.

The number of bit lines included in each of groups of a plurality of bit lines is not limited. The number of bit lines included in each group may vary depending on a structure characteristic or a required specification of the nonvolatile memory device 100.

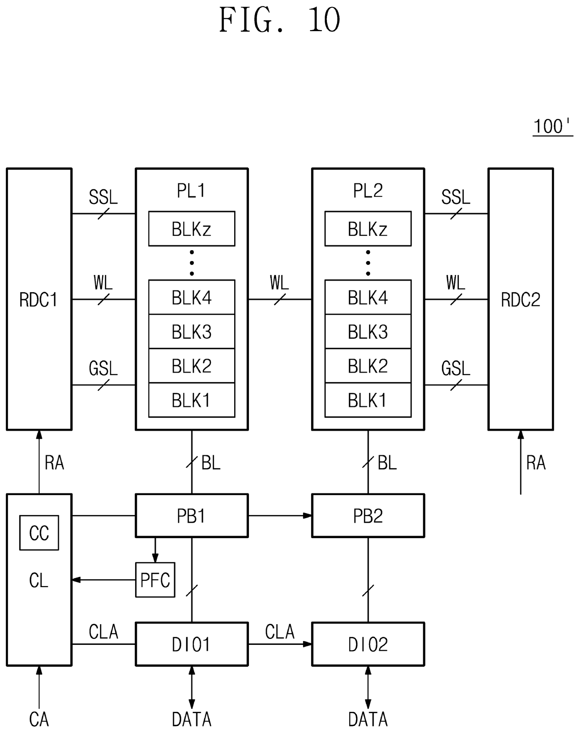

FIG. 10 illustrates an example of a nonvolatile memory device 100' according to an application example for performing a partial access operation in a state where at least some of partial cell strings do not act as the load of word lines.

Referring to FIG. 10, the nonvolatile memory device 100' includes the first plane PL1, the second plane PL2, the first row decoder RDC1, the second row decoder RDC2, the first page buffer PB1, the second page buffer PB2, the pass/fail check block PFC, the first data input and output circuit DIO1, the second data input and output circuit DIO2, and the control logic circuit CL.

Compared to the nonvolatile memory device 100 of FIG. 1, the string selection lines SSL and the ground selection lines GSL may be separated between the first plane PL1 and the second plane PL2 without connection with each other. For example, the first row decoder RDC1 may select the first plane PL1 by using the string selection lines SSL and the ground selection lines GSL. Also, the second row decoder RDC2 may select the second plane PL2 by using the string selection lines SSL and the ground selection lines GSL.

In an embodiment, the word lines WL may be connected in common between the first plane PL1 and the second plane PL2. The first row decoder RDC1 and the second row decoder RDC2 may bias the first plane PL1 and the second plane PL2 through common word lines WLs.

The components of the nonvolatile memory device 100' may be configured to be identical to those described with reference to the nonvolatile memory device 100 of FIG. 1 except for the connection relationship between the first plane PL1 and the second plane PL2. Thus, additional description will be omitted to avoid redundancy.

In an embodiment, each of the first to z-th memory blocks BLK1 to BLKz of the first plane PL1 and the second plane PL2 may include the cell strings described with reference to FIGS. 2 and 4 or FIGS. 6 and 7.

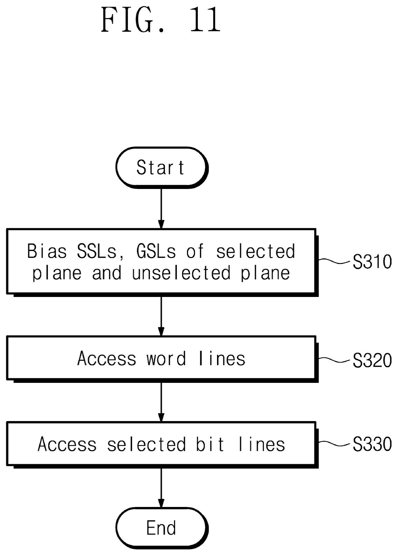

FIG. 11 illustrates an example of an operation method of the nonvolatile memory device 100' of FIG. 10. Referring to FIG. 10 and 11, in operation S310, the nonvolatile memory device 100' may bias string selection lines SSL and ground selection lines GSL of a selected plane and an unselected plane.

For example, one of the first row decoder RDC1 and the second row decoder RDC2 may bias voltages for the partial access operation to a plane corresponding to the one row decoder from among the first plane PL1 and the second plane PL2 through the string selection lines SSL and the ground selection lines GSL. The other of the first row decoder RDC1 and the second row decoder RDC2 may bias voltages for floating cell strings of a plane corresponding to the other row decoder from among the first plane PL1 and the second plane PL2 through the string selection lines SSL and the ground selection lines GSL.

In operation S320, the nonvolatile memory device 100' may access word lines. When the nonvolatile memory device 100' accesses the word lines, the first plane PL1 and the second plane PL2 may bias the cell strings of the first plane PL1 and the second plane PL2 through the common word lines WLs.

In operation S330, the nonvolatile memory device 100' may access bit lines selected for the partial access operation.

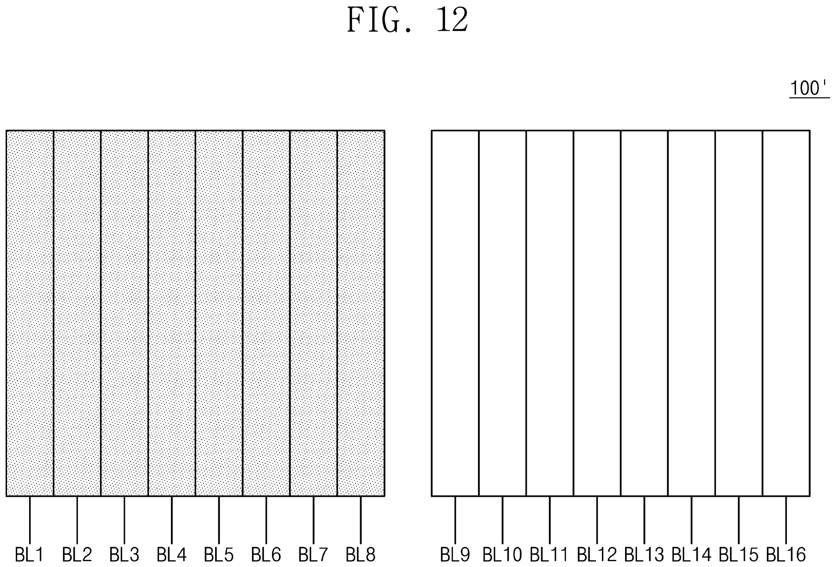

FIG. 12 illustrates an example in which cell strings are floated by the nonvolatile memory device 100' of FIG. 10 and the operation method of FIG. 11. In FIG. 12, the first to eighth bit lines BL1 to BL8 may be included in the first plane PL1, and the ninth to sixteenth bit lines BL9 to BL16 may be included in the second plane PL2. In an embodiment, it is assumed that the first to eighth bit lines BL1 to BL8 share one common source line and the ninth to sixteenth bit lines BL9 to BL16 share one common source line.

Referring to FIGS. 2, 10, and 12, when there is performed the partial access operation on the first to eighth bit lines BL1 to BL8, the first row decoder RDC1 may turn on string selection transistors and ground selection transistors of cell strings corresponding to the first to eighth bit lines BL1 to BL8. Accordingly, the load of the cell strings connected to the first to eighth bit lines BL1 to BL8 targeted for the partial access operation may be applied to the word lines WLs.

The second row decoder RDC2 may turn off string selection transistors and ground selection transistors of cell strings corresponding to the ninth to sixteenth bit lines BL9 to BL16. Accordingly, the load of the cell strings connected to the ninth to sixteenth bit lines BL9 to BL16 in the partial access operation may not be applied to the word lines WLs.

As another example, the partial access operation may be performed on some of the first to eighth bit lines BL1 to BL8, for example, on the first to fourth bit lines BL1 to BL4. The first row decoder RDC1 may turn on the string selection transistors of the cell strings corresponding to the first to fourth bit lines BL1 to BL4. The first row decoder RDC1 may turn off the string selection transistors of the cell strings corresponding to the fifth to eighth bit lines BL5 to BL8. The first row decoder RDC1 may turn on the ground selection transistors of the cell strings corresponding to the first to eighth bit lines BL1 to BL8.

The second row decoder RDC2 may turn off the string selection transistors and the ground selection transistors corresponding to the ninth to sixteenth bit lines BL9 to BL16. Accordingly, the load of the cell strings connected to the ninth to sixteenth bit lines BL9 to BL16 not targeted for the partial access operation not may not be applied to the word lines WLs.

For example, when there is performed the partial access operation on the first to fourth bit lines BL1 to BL4, the word lines WLs may experience only the capacitances of the cell strings of the first to eighth bit lines BL1 to BL8, not the capacitances of the cell strings corresponding to the first to sixteenth bit lines BL1 to BL16.

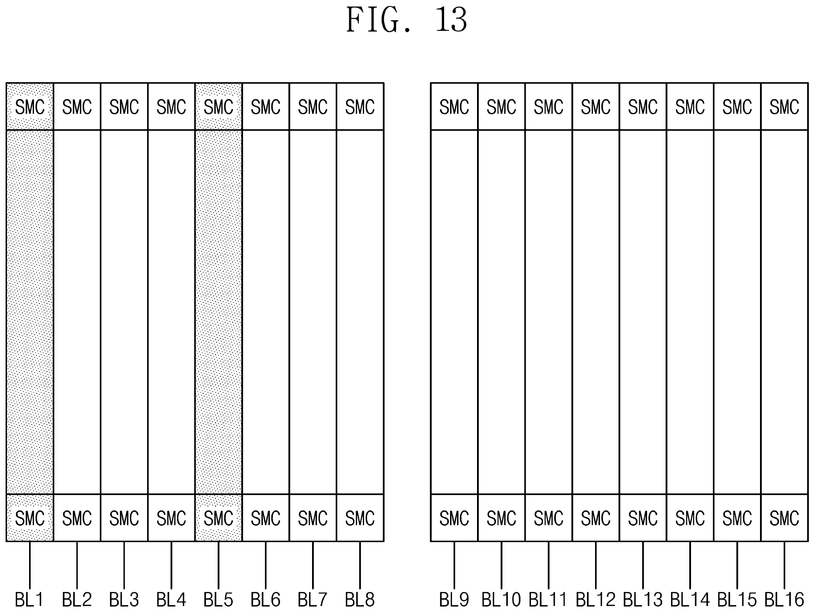

FIG. 13 illustrates an application example in which cell strings are floated by the nonvolatile memory device 100' of FIG. 10 and the operation method of FIG. 11. In FIG. 13, the first to eighth bit lines BL1 to BL8 may be included in the first plane PL1, and the ninth to sixteenth bit lines BL9 to BL16 may be included in the second plane PL2. In an embodiment, it is assumed that the first to eighth bit lines BL1 to BL8 share one common source line and the ninth to sixteenth bit lines BL9 to BL16 share one common source line. As described with reference to FIGS. 1 to 9, the special memory cells may be provided at opposite ends of the cell strings of FIG. 13.

Referring to FIGS. 7, 10, and 13, when there is performed the partial access operation on the first and fifth bit lines BL1 and BL5, the first row decoder RDC1 may turn on string selection transistors and ground selection transistors of cell strings corresponding to the first to eighth bit lines BL1 to BL8. Also, the first row decoder RDC1 may turn on the special memory cells SMC of the cell strings corresponding to the first and fifth bit lines BL1 and BL5 and may control the special memory cells SMC of the cell strings corresponding to the second to fourth bit lines BL2 to BL4 and the fifth to eighth bit lines BL5 and BL8 such that a current flow corresponding to the second to fourth bit lines BL2 to BL4 and the fifth to eighth bit lines BL5 and BL8 is blocked. Accordingly, the load of the cell strings connected to the first and fifth bit lines BL1 to BL5 targeted for the partial access operation may be applied to the word lines WLs.

The second row decoder RDC2 may turn off string selection transistors and ground selection transistors of cell strings corresponding to the ninth to sixteenth bit lines BL9 to BL16. Accordingly, the load of the cell strings connected to the ninth to sixteenth bit lines BL9 to BL16 not targeted for the partial access operation may not be applied to the word lines WLs.

As the string selection lines SSL and the ground selection lines GSL of the first plane PL1 and the second plane PL2 are separated and the special memory cells SMC are provided in the cell strings, as described above, the minimum unit of the partial access operation may be further decreased.

In an embodiment, an operation of floating cell strings of one of the first plane PL1 and the second plane PL2 by using the first row decoder RDC1 and the second row decoder RDC2 may be controlled by the capacitance control circuit CC. Also, operations of programming the special memory cells SMC and appropriately applying the first voltage V1 and the second voltage V2 for the partial access operation to special word lines may be controlled by the capacitance control circuit CC.

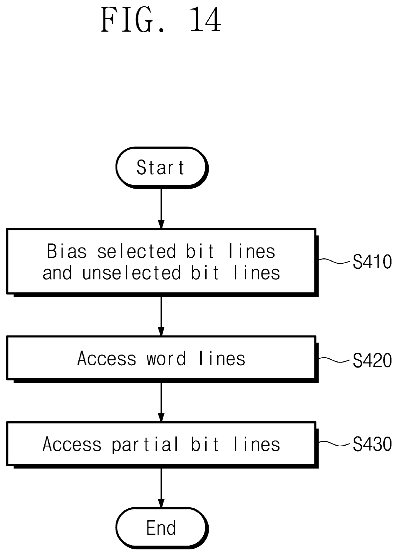

FIG. 14 illustrates an example of an operation method of the nonvolatile memory device 100 or 100' of FIG. 1 or 10. Referring to FIGS. 1, 10, and 14, in operation S410, the nonvolatile memory device 100 or 100' may bias selected bit lines and unselected bit lines.

For example, the first page buffer PB1 and the second page buffer PB2 may apply third voltages V3 to bit lines selected for the partial access operation from among a plurality of bit lines. For example, the third voltages V3 may be a voltage biased to cell strings through string selection transistors for the partial access operation (or the access operation) and may have levels by which the string selection transistors are not turned off.

The first page buffer PB1 and the second page buffer PB2 may apply fourth voltages V4 to bit lines not selected for the partial access operation from among the plurality of bit lines. For example, the fourth voltages V4 may have levels by which the string selection transistors are turned off when supplied to the string selection transistors.

In operation S420, the nonvolatile memory device 100' may access word lines. When the nonvolatile memory device 100' accesses the word lines, the first plane PL1 and the second plane PL2 may bias the cell strings of the first plane PL1 and the second plane PL2 through the common word lines WLs.

In operation S430, the nonvolatile memory device 100' may access partial bit lines selected for the partial access operation. In an embodiment, string selection transistors of cell strings corresponding to the bit lines not selected for the partial access operation may be turned off. Accordingly, the bit lines not selected for the partial access operation may not be accessed.

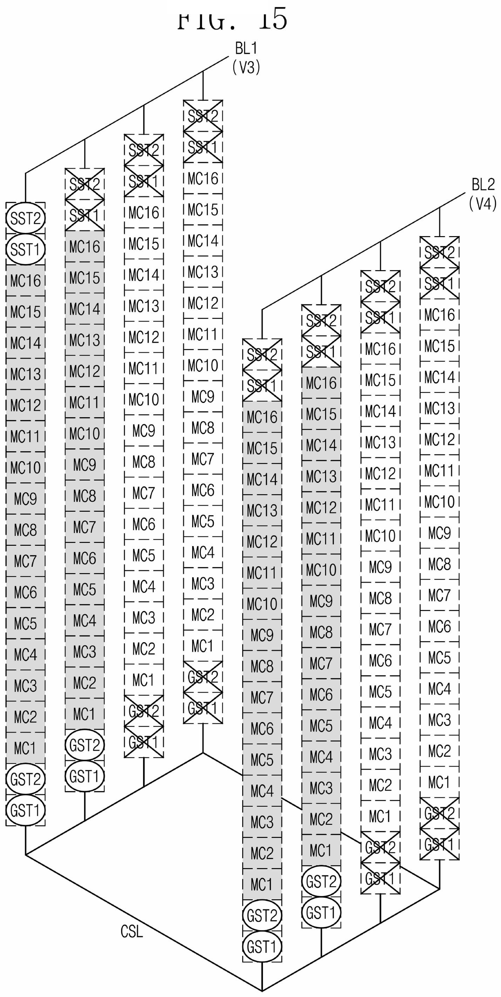

FIG. 15 illustrates an example in which the operation method of FIG. 14 is performed in cell strings of FIG. 2. Referring to FIG. 1 or 10 and FIGS. 14 and 15, a cell string at the first row and first column, which is connected to the first string selection line SSL1 and the first bit line BL1 may be selected for the partial read operation.

The third voltage V3 may be applied to the first bit line BL1, and the first string selection transistor SST1 and the second string selection transistor SST2 of the third partial cell string at the first row and the first column may be turned on. The first ground selection transistor GST1 and the second ground selection transistor GST2 of the third partial cell string may be turned on. Accordingly, the third partial cell string at the first row and first column may act as the load of the first to sixteenth word lines WL1 to WL16.

The first and second string selection transistors SST1 and SST2 of the fourth partial cell string at the second row and first column, which is connected to the second string selection line SSL2 and the first bit line BL1, may be turned off, and the first and second ground selection transistors GST1 and GST2 may be turned on. Accordingly, the fourth partial cell string at the second row and first column may act as the load of the first to sixteenth word lines WL1 to WL16.

In an embodiment, the second bit line BL2 may not be selected for the partial access operation. Accordingly, string selection transistors connected to the second bit line BL2 may be turned off by the fourth voltage V4.

The first and second ground selection transistors GST1 and GST2 of the fourth partial cell string at the first row and second column may be turned on. Accordingly, the fourth partial cell string at the first row and second column may act as the load of the first to sixteenth word lines WL1 to WL16.

The first and second ground selection transistors GST1 and GST2 of the fourth partial cell string at the second row and second column may be turned on. Accordingly, the fourth partial cell string at the second row and second column may act as the load of the first to sixteenth word lines WL1 to WL16.

As described above, the nonvolatile memory device 100 according to an embodiment of the present disclosure may suppress a voltage from being supplied to the cell string at the second row and first column from the first bit line BL1 through the first and second string selection transistors SST1 and SST2, and thus, the load of the cell string at the second row and first column may be decreased.

In an embodiment, to turn off the first or second string selection transistor SST1 or SST2 by using the fourth voltage V4 of the second bit line BL2 may include removing a turn-on condition of the first or second string selection transistor SST1 or SST2 by setting the fourth voltage V4 to be higher than or equal to the gate voltage of the first or second string selection transistor SST1 or SST2.

In an embodiment, the partial access command (or the full access command) may include a partial write command (or a full write command), a partial read command (or a full read command), a partial program verify read command (or a full program verify read command), or a partial erase verify read command (or a full erase verify read command). The method described with reference to FIGS. 1 to 15 may be modified and applied depending on a kind of the partial access command without departing from the technical idea of the present disclosure.

In an embodiment, operations of applying the third voltages V3 and the fourth voltages V4 for the partial access operation to the plurality of bit lines BL may be controlled by the capacitance control circuit CC.

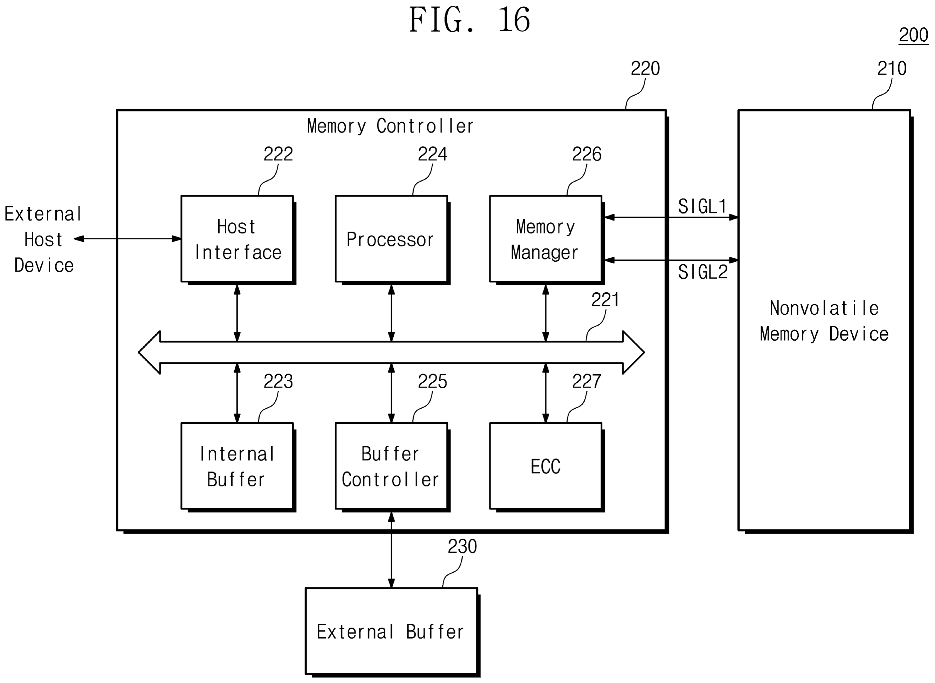

FIG. 16 illustrates a storage device 200 according to an embodiment of the present disclosure. Referring to FIG. 16, the storage device 200 may include a nonvolatile memory device 210, a memory controller 220, and an external buffer 230. The nonvolatile memory device 210 may include a plurality of memory cells. Each of the plurality of memory cells may store two or more bits.

For example, the nonvolatile memory device 210 may include at least one of various nonvolatile memory devices such as a flash memory device, a phase-change memory device, a ferroelectric memory device, a magnetic memory device, and a resistive memory device.

The memory controller 220 may receive various requests for writing data in the nonvolatile memory device 210 or reading data from the nonvolatile memory device 210, from an external host device. The memory controller 220 may store (or buffer) user data communicated with the external host device in the external buffer 230 and may store meta data for managing the storage device 200 in the external buffer 230.

The memory controller 220 may access the nonvolatile memory device 210 through first signal lines SIGL1 and second signal lines SIGL2. For example, the memory controller 220 may transmit a command and an address to the nonvolatile memory device 210 through the first signal lines SIGL1. The memory controller 220 may exchange data with the nonvolatile memory device 210 through the first signal lines SIGL1. In an embodiment, signal lines communicating the command and the address and signal lines exchanging data may be the same signal lines or may be separated signal lines.

The memory controller 220 may transmit a first control signal to the nonvolatile memory device 210 through the second signal lines SIGL2. The memory controller 220 may receive a second control signal from the nonvolatile memory device 210 through the second signal lines SIGL2.

In an embodiment, the memory controller 220 may be configured to control two or more nonvolatile memory devices. The memory controller 220 may provide first signal lines and second signal lines independently for each of the two or more nonvolatile memory devices.

As another example, the memory controller 220 may share one first signal line with the two or more nonvolatile memory devices. The memory controller 220 may share some of the second signal lines with the two or more nonvolatile memory devices and may separately provide the others thereof.

The external buffer 230 may include a random access memory. For example, the external buffer 230 may include at least one of a dynamic random access memory, a phase-change random access memory, a ferroelectric random access memory, a magnetic random access memory, and a resistive random access memory.

The memory controller 220 may include a bus 221, a host interface 222, an internal buffer 223, a processor 224, a buffer controller 225, a memory manager 226, and an error correction code (ECC) block 227.

The bus 221 may provide communication channels between the components of the memory controller 220. The host interface 222 may receive various requests from the external host device and may parse the received requests. The host interface 222 may store the parsed requests in the internal buffer 223.

The host interface 222 may transmit various responses to the external host device. The host interface 222 may exchange signals with the external host device in compliance with a given communication protocol. The internal buffer 223 may include a random access memory. For example, the internal buffer 223 may include a static random access memory or a dynamic random access memory.

The processor 224 may execute an operating system or firmware for driving the memory controller 220. The processor 224 may read the parsed requests stored in the internal buffer 223 and may generate command and addresses for controlling the nonvolatile memory device 210. The processor 224 may provide the generated command and addresses to the memory manager 226.

The processor 224 may store various meta data for managing the storage device 200 in the internal buffer 223. The processor 224 may access the external buffer 230 through the buffer controller 225. The processor 224 may control the buffer controller 225 and the memory manager 226 such that the user data stored in the external buffer 230 are provided to the nonvolatile memory device 210.

The processor 224 may control the host interface 222 and the buffer controller 225 such that the data stored in the external buffer 230 are provided to the external host device. The processor 224 may control the buffer controller 225 and the memory manager 226 such that the data received from the nonvolatile memory device 210 are stored in the external buffer 230. The processor 224 may control the host interface 222 and the buffer controller 225 such that the data received from the external host device are stored in the external buffer 230.

Under control of the processor 224, the buffer controller 225 may write data in the external buffer 230 or may read data from the external buffer 230. The memory manager 226 may communicate with the nonvolatile memory device 210 through the first signal lines SIGL1 and the second signal lines SIGL2 under control of the processor 224.

The memory manager 226 may access the nonvolatile memory device 210 under control of the processor 224. For example, the memory manager 226 may access the nonvolatile memory device 210 through the first signal lines SIGL1 and the second signal lines SIGL2. The memory manager 226 may communicate with the nonvolatile memory device 210, based on a protocol defined in compliance with the standard or defined by a manufacturer.

The error correction code block 227 may perform error correction encoding for data to be provided to the nonvolatile memory device 210 by using the error correction code ECC. The error correction code block 227 may perform error correction decoding for data received from the nonvolatile memory device 210 by using the error correction code ECC.

In an embodiment, the external buffer 230 and the buffer controller 225 may be omitted in the storage device 200. When the external buffer 230 and the buffer controller 225 are omitted, the functions which are described as being performed by the external buffer 230 and the buffer controller 225 may be performed by the internal buffer 223.

In an embodiment, the nonvolatile memory device 210 may include the nonvolatile memory device 100 or 100' described with reference to FIGS. 1 to 15. The nonvolatile memory device 210 may access the word lines based on a partial capacitance in response to the partial access command and may access the word lines based on a full capacitance in response to the full access command. Accordingly, a power necessary for the nonvolatile memory device 210 to drive the word lines may be decreased.

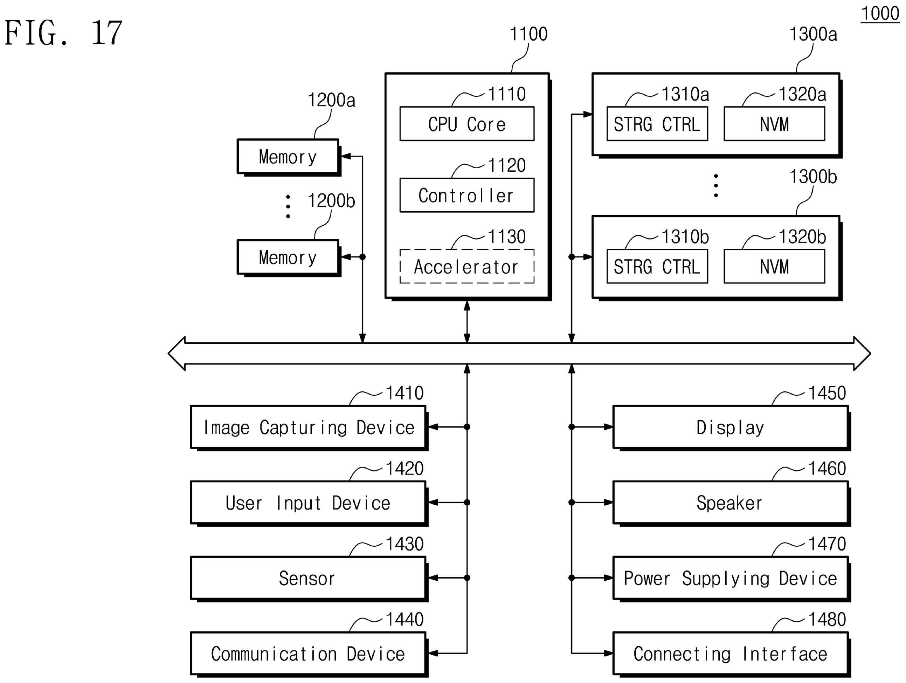

FIG. 17 is a diagram of a system to which a storage device is applied, according to an embodiment. A system 1000 of FIG. 17 may basically be a mobile system, such as a portable communication terminal (e.g., a mobile phone), a smartphone, a tablet personal computer (PC), a wearable device, a healthcare device, or an Internet of things (IOT) device. However, the system 1000 of FIG. 16 is not necessarily limited to the mobile system and may be a PC, a laptop computer, a server, a media player, or an automotive device (e.g., a navigation device).

Referring to FIG. 17, the system 1000 may include a main processor 1100, memories (e.g., 1200a and 1200b), and storage devices (e.g., 1300a and 1300b). In addition, the system 1000 may include at least one of an image capturing device 1410, a user input device 1420, a sensor 1430, a communication device 1440, a display 1450, a speaker 1460, a power supplying device 1470, and a connecting interface 1480.

The main processor 1100 may control all operations of the system 1000, more specifically, operations of other components included in the system 1000. The main processor 1100 may be implemented as a general-purpose processor, a dedicated processor, or an application processor.

The main processor 1100 may include at least one CPU core 1110 and further include a controller 1120 configured to control the memories 1200a and 1200b and/or the storage devices 1300a and 1300b. In some embodiments, the main processor 1100 may further include an accelerator 1130, which is a dedicated circuit for a high-speed data operation, such as an artificial intelligence (AI) data operation. The accelerator 1130 may include a graphics processing unit (GPU), a neural processing unit (NPU) and/or a data processing unit (DPU) and be implemented as a chip that is physically separate from the other components of the main processor 1100.

The memories 1200a and 1200b may be used as main memory devices of the system 1000. Although each of the memories 1200a and 1200b may include a volatile memory, such as static random access memory (SRAM) and/or dynamic RAM (DRAM), each of the memories 1200a and 1200b may include non-volatile memory, such as a flash memory, phase-change RAM (PRAM) and/or resistive RAM (RRAM). The memories 1200a and 1200b may be implemented in the same package as the main processor 1100.

The storage devices 1300a and 1300b may serve as non-volatile storage devices configured to store data regardless of whether power is supplied thereto, and have larger storage capacity than the memories 1200a and 1200b. The storage devices 1300a and 1300b may respectively include storage controllers (STRG CTRL) 1310a and 1310b and NVM (nonvolatile memory)s 1320a and 1320b configured to store data via the control of the storage controllers 1310a and 1310b. Although the NVMs 1320a and 1320b may include flash memories having a two-dimensional (2D) structure or a three-dimensional (3D) V-NAND structure, the NVMs 1320a and 1320b may include other types of NVMs, such as PRAM and/or RRAM.

The storage devices 1300a and 1300b may be physically separated from the main processor 1100 and included in the system 1000 or implemented in the same package as the main processor 1100. In addition, the storage devices 1300a and 1300b may have types of solid-state devices (SSDs) or memory cards and be removably combined with other components of the system 100 through an interface, such as the connecting interface 1480 that will be described below. The storage devices 1300a and 1300b may be devices to which a standard protocol, such as a universal flash storage (UFS), an embedded multi-media card (eMMC), or a non-volatile memory express (NVMe), is applied, without being limited thereto.

The image capturing device 1410 may capture still images or moving images. The image capturing device 1410 may include a camera, a camcorder, and/or a webcam.

The user input device 1420 may receive various types of data input by a user of the system 1000 and include a touch pad, a keypad, a keyboard, a mouse, and/or a microphone.

The sensor 1430 may detect various types of physical quantities, which may be obtained from the outside of the system 1000, and convert the detected physical quantities into electric signals. The sensor 1430 may include a temperature sensor, a pressure sensor, an illuminance sensor, a position sensor, an acceleration sensor, a biosensor, and/or a gyroscope sensor.

The communication device 1440 may transmit and receive signals between other devices outside the system 1000 according to various communication protocols. The communication device 1440 may include an antenna, a transceiver, and/or a modem.

The display 1450 and the speaker 1460 may serve as output devices configured to respectively output visual information and auditory information to the user of the system 1000.

The power supplying device 1470 may appropriately convert power supplied from a battery (not shown) embedded in the system 1000 and/or an external power source, and supply the converted power to each of components of the system 1000.

The connecting interface 1480 may provide connection between the system 1000 and an external device, which is connected to the system 1000 and capable of transmitting and receiving data to and from the system 1000. The connecting interface 1480 may be implemented by using various interface schemes, such as advanced technology attachment (ATA), serial ATA (SATA), external SATA (e-SATA), small computer small interface (SCSI), serial attached SCSI (SAS), peripheral component interconnection (PCI), PCI express (PCIe), NVMe, IEEE 1394, a universal serial bus (USB) interface, a secure digital (SD) card interface, a multi-media card (MMC) interface, an eMMC interface, a UFS interface, an embedded UFS (eUFS) interface, and a compact flash (CF) card interface.

In an embodiment, the storage device 200 described with reference to FIG. 16 may be implemented with each of the storage devices 1300a and 1300b. Each of the NVMs 1320a and 1320b may include the nonvolatile memory device 210 of FIG. 16. Each of the NVMs 1320a and 1320b may access the word lines based on a partial capacitance in response to the partial access command and may access the word lines based on a full capacitance in response to the full access command. Accordingly, a power necessary for each of the NVMs 1320a and 1320b to drive the word lines may be decreased.

In the above embodiments, components according to the present disclosure are described by using the terms "first", "second", "third", etc. However, the terms "first", "second", "third", etc. may be used to distinguish components from each other and do not limit the present disclosure. For example, the terms "first", "second", "third", etc. do not involve an order or a numerical meaning of any form.

In the above embodiments, components according to embodiments of the present disclosure are referenced by using blocks. The blocks may be implemented with various hardware devices, such as an integrated circuit (IC), an application specific IC (ASIC), a field programmable gate array (FPGA), and a complex programmable logic device (CPLD), firmware driven in hardware devices, software such as an application, or a combination of a hardware device and software. Also, the blocks may include circuits implemented with semiconductor elements in an integrated circuit, or circuits enrolled as an intellectual property (IP).

According to an embodiment of the present disclosure, when a partial page is accessed, word lines are biased to correspond to capacitances of the partial page, not the whole page. Accordingly, a nonvolatile memory device reducing power consumption, an operation method of the nonvolatile memory device, and a storage device including the nonvolatile memory device are provided.

While the present disclosure has been described with reference to embodiments thereof, it will be apparent to those of ordinary skill in the art that various changes and modifications may be made thereto without departing from the scope of the present invention as set forth in the following claims.

## Claims

1. A nonvolatile memory device (100) comprising:
a memory cell array including a plurality of cell strings having a plurality of memory cells (MC1 to MC8) classified into pages;
a row decoder (RDC1, RDC2) connected to the memory cell array through string selection lines (SSL), ground selection lines (GSL), and word lines (WL) and configured to apply voltages to the string selection lines (SSL) and the ground selection lines (GSL); and
a page buffer (PB1, PB2) connected to the memory cell array through bit lines (BL) and configured to apply voltages to the bit lines (BL),
wherein, in response to that a read command for a first page is received from an external device, the row decoder (RDC1, RDC2) is configured to apply first voltages to the word lines to correspond to first capacitances of memory cells (MC1 to MC8) of the first page,
wherein, in response to that a read command for a first partial page of the first page is received from the external device, the row decoder (RDC1, RDC2) is configured to apply second voltages to the word lines to correspond to second capacitances of memory cells (MC1 to MC8) of the first partial page,
wherein the nonvolatile memory device (100) is configured such that a channel of each cell string is formed to have a channel voltage in response to the voltages being applied to the string selection lines (SSL), the ground selection lines (GSL), the word lines (WL), and the bit lines (BL),
wherein the nonvolatile memory device (100) is configured such that the first capacitances are formed between channels of strings connected to bit lines (BL) associated with the first page and the word lines (WL) being applied with the first voltages,
wherein the nonvolatile memory device (100) is configured such that the second capacitances are formed between channels of strings connected to bit lines (BL) associated with the first partial page and the word lines (WL) being applied with the second voltages, and
wherein an amount of the second capacitances is less than an amount of the first capacitances.

2. The nonvolatile memory device (100) of claim 1, wherein the page buffer (PB1, PB2) is configured to access memory cells (MC1 to MC8) connected to bit lines (BL) corresponding to the first partial page.

3. The nonvolatile memory device (100) of claim 1 or claim 2, wherein:
each of the plurality of cell strings includes ground selection transistors (GST1, GST2) sequentially stacked, memory cells (MC1 to MC8) on the ground selection transistors (GST1, GST2), and string selection transistors (SST1, SST2) on the memory cells (MC1 to MC8),
the ground selection transistors (GST1, GST2) are connected to the ground selection lines (GSL),
the string selection transistors (SST1, SST2) are connected to the string selection lines (SSL),
the memory cells (MC1 to MC8) are connected to the word lines (WL),
the memory cells include special memory cells (SMC1 to SMC8) configured to be programmed to have a predetermined state and normal memory cells (MC1 to MC8) configured to store user data, and
the word lines (WL) include special word lines (SWL1 to SWL8) connected to the special memory cells (SMC1 to SMC8) and normal word lines (WL) connected to the normal memory cells (MC1 to MC8).

4. The nonvolatile memory device (100) of claim 3, wherein, in response to the read command for the first page, the row decoder (RDC1, RDC2) is configured to turn on the special memory cells (SMC1 to SMC8), and
wherein, in response to the read command for the first partial page, the row decoder (RDC1, RDC2) is configured to selectively turn on and turn off the special memory cells (SMC1 to SMC8).

5. The nonvolatile memory device (100) of claim 3 or claim 4, wherein the special memory cells (SMC1 to SMC8) include first special memory cells (SMC1 to SCM4) adjacent to the ground selection transistors (GST1, GST2) and second special memory cells (SMC5 to SMC8) adjacent to the string selection transistors (SST1, SST2), and
wherein the normal memory cells (MC1 to MC8) are placed between the first special memory cells (SMC1 to SMC4) and the second special memory cells (SMC5 to SMC8).

6. The nonvolatile memory device (100) of claim 5, wherein, in response to the read command for the first partial page, the row decoder (RDC1, RDC2) is configured to turn on first special memory cells (SMC1 to SMC4) and second special memory cells (SMC5 to SMC8) corresponding to the first partial page and to turn off first special memory cells (SMC1 to SMC4) and second special memory cells (SMC5 to SMC8) not corresponding to the first partial page.

7. The nonvolatile memory device (100) of any of claims 3-6, wherein the special memory cells (SMC1 to SMC8) are programmed to have one of a plurality of threshold voltages.

8. The nonvolatile memory device (100) of claim 7, wherein special memory cells (SMC1 to SMC8) connected in common to one special word line (SWL1 to SWL8) are programmed to have different threshold voltages depending on a direction of the bit lines (BL).

9. The nonvolatile memory device (100) of claim 7 or claim 8, wherein special memory cells (SMC1 to SMC8) connected in common to one special word line (SWL1 to SWL8) are programmed to have different threshold voltages depending on a direction of the string selection lines (SSL).

10. The nonvolatile memory device (100) of any of claims 7-9, wherein the plurality of memory cells (MC1 to MC8) are classified into a plurality of groups depending on a direction of the bit lines (BL), and
wherein special memory cells (SMC1 to SMC8) connected to one special word line (SWL1 to SWL8) are programmed to have the same threshold voltage in the same group and are programmed to have different threshold voltages in different groups.

11. The nonvolatile memory device (100) of any preceding claim, wherein the memory cell array includes a first plane (PL1) including first memory cells and a second plane (PL2) including second memory cells, and
wherein the row decoder includes a first row decoder (RDC1) connected to the first plane (PL1) and a second row decoder (RDC2) connected the second plane (PL2).

12. The nonvolatile memory device (100) of claim 11, wherein, in response to the read command for the first page, the first row decoder (RDC1) and the second row decoder (RDC2) are configured to apply voltages to the string selection lines (SSL) and the ground selection lines (GSL), and
wherein, in response to the read command for the first partial page, one of the first row decoder (RDC1) and the second row decoder (RDC2) is configured to apply voltages to some of the string selection lines (SSL) and some of the ground selection lines (GSL).

13. The nonvolatile memory device (100) of claim 11 or claim 12, wherein the first plane (PL1) and the second plane (PL2) are connected in common to the word lines (WL),
wherein the first plane (PL1) is connected to the first row decoder (RDC1) through first string selection lines (SSL) and first ground selection lines (GSL), and
wherein the second plane (PL2) is connected to the second row decoder (RDC2) through second string selection lines (SSL) and second ground selection lines (GSL).

14. The nonvolatile memory device (100) of any preceding claim, wherein, in response to the read command for the first page, the page buffer (PB1, PB2) is configured to apply voltages to the bit lines (BL) for accessing the memory cells (MC1 to MC8) of the first page, and
wherein, in response to the read command for the first partial page, the page buffer (PB1, PB2) is configured to apply voltages to bit lines (BL) corresponding to the memory cells (MC1 to MC8) of the first partial page from among the bit lines (BL) for accessing the memory cells (MC1 to MC8) of the first partial page.

15. An operation method of a nonvolatile memory device (100) which includes a memory cell array including a plurality of cell strings having a plurality of memory cells (MC1 to MC8) classified into pages, the method comprising:
applying voltages to the memory cell array through string selection lines (SSL), ground selection lines (GSL), and bit lines (BL);
applying first voltages to word lines (WL) to correspond to first capacitances of memory cells (MC1 to MC8) of a first page in response to that a read command for the first page is received from an external device;
applying second voltages to the word lines (WL) to correspond to second capacitances of memory cells (MC1 to MC8) of a first partial page of the first page in response to that a read command for the first partial page is received from the external device; and
forming a channel of each cell string having a channel voltage by applying the voltages to the string selection lines (SSL), the ground selection lines (GSL), the word lines (WL), and the bit lines (BL),
wherein the first capacitances are formed between channels of strings connected to bit lines (BL) associated with the first page and the word lines (WL) being applied with the first voltages, and
wherein the second capacitances different from the first capacitances are formed between channels of strings connected to bit lines (BL) associated with the first partial page and the word lines (WL) being applied with the second voltages.
